# EUROPÄISCHE PATENTANMELDUNG

(11) **EP 2 249 101 A1**
(43) Veröffentlichungstag der Anmeldung: **10.11.2010**
(21) Anmeldenummer: 10169344.8
(22) Anmeldetag: 23.03.2009
(51) Int. Cl.: F24J 2/10, F24J 2/18, H01L 31/052, F24J 2/54

(54) **Photovoltaik-Anordnung**

(62) Teilanmeldung aus: 09155866.8
(71) Anmelder: Metzler, Richard, 82343 Pöcking (DE)
(72) Erfinder: Metzler, Richard, 82343 Pöcking (DE)
(74) Vertreter: Sandmann, Wolfgang

(57) **Zusammenfassung**

Photovoltaik-Anordnung zur Erzeugung von elektrischem Strom aus Licht mit a) einer Photovoltaikanlage mit einer Vielzahl von Photovoltaikmodulen (31-39), b) eine Anzahl M von Leitspiegeln; und c) eine Anzahl N von Reflektoren, die dazu eingerichtet sind, zumindest einen Teil der einfallenden Lichtes auf die Leitspiegel und von dort weiter auf die Photovoltaikanlage zu reflektieren.

## Beschreibung

Die Erfindung betrifft eine Photovoltaik-Anordnung zur Erzeugung von elektrischem Strom aus Licht.

Eine Photovoltaik-Anordnung zur Erzeugung von elektrischem Strom aus Licht umfasst insbesondere eine Photovoltaikanlage mit einer Vielzahl von Photovoltaikmodulen zum direkten Umwandeln einfallenden Lichtes in elektrischen Strom. Dabei stellen Photovoltaikanlagen eine der wichtigsten Möglichkeiten zur Erzeugung regenerativer Energie dar. Neben ihrem Vorteil der direkten Erzeugung von elektrischem Strom aus Licht, insbesondere Sonnenlicht, haben Photovoltaikanlagen den Vorteil der einfachen und dezentralen Installationsmöglichkeit. Allerdings eignen sich für eine sinnvolle Installation einer Photovoltaikanlage in Mittel- und Nordeuropa nur begrenzte Flächen, wie Dachflächen in Südlage ohne Verschattung, ohne zusätzliche Subventionen.

Zur Steigerung der Effizienz und Leistungsfähigkeit einer Photovoltaikanlage ist es bekannt, Spiegel einzusetzen, um Licht auf die Photovoltaikanlage zu leiten. Herkömmliche Spiegel zur Steigerung der auf eine Photovoltaikanlage einfallenden Lichtmenge sind aus der DE 100 26 014 A1, der DE 100 25 860 A1, der DE 198 14 617 A1 und der DE 34 151 12 A1 bekannt.

Diese herkömmlichen Spiegel der oben zitierten Druckschriften haben jedoch gemeinsam, dass diese vorgeschlagenen Spiegel relativ komplex konzipiert und damit teuer in ihrer Herstellung sind.

Bei Photovoltaikanlagen ist weiter besonders beachtenswert, dass zusätzliche Spiegel oder Reflektoren nur dann sinnvoll eingesetzt werden können, wenn diese im Vergleich zu den Photovoltaikmodulen der Photovoltaikanlage deutlich preiswerter sind. Anderenfalls wäre es einfacher und kostengünstiger, die Anzahl der verwendeten Photovoltaikmodule zu erhöhen.

Eine Aufgabe der vorliegenden Erfindung liegt demnach darin, die Effizienz einer Photovoltaikanlage auf kostengünstige Weise zu verbessern.

Erfindungsgemäß wird diese gestellte Aufgabe durch eine Photovoltaik-Anordnung zur Erzeugung von elektrischem Strom aus Licht mit den Merkmalen des Patentanspruchs 1 und/oder durch eine Photovoltaik-Anordnung zur Erzeugung von elektrischem Strom aus Licht mit den Merkmalen des Patentanspruchs 8 und/oder durch eine Photovoltaik-Anordnung zur Erzeugung von elektrischem Strom aus Licht mit den Merkmalen des Patentanspruchs 15 gelöst.

Demgemäß wird eine Photovoltaik-Anordnung zur Erzeugung von elektrischem Strom aus Licht vorgeschlagen, welche aufweist:
- eine Photovoltaikanlage mit einer vorbestimmten Fläche, welche eine Vielzahl von Photovoltaikmodulen hat; und
- eine Anzahl N von Reflektoren, wobei der jeweilige Reflektor großflächig gegenüber der Fläche der Photovoltaikanlage ist und dazu eingerichtet ist, zumindest einen Teil eines auf den Reflektor einfallenden Lichtes auf die Photovoltaikanlage zu reflektieren.

Ferner wird eine Photovoltaik-Anordnung zur Erzeugung von elektrischem Strom aus Licht vorgeschlagen, welche aufweist:
- eine Photovoltaikanlage mit einer Vielzahl von Photovoltaikmodulen;
- eine Anzahl N von Reflektoren, welche dazu eingerichtet sind, zumindest einen Teil des auf die Anzahl N von Reflektoren einfallenden Lichtes auf eine Anzahl M von Leitspiegeln zu reflektieren; und
- die Anzahl M von Leitspiegeln, welche derart angeordnet sind, um das von der Anzahl N der Reflektoren reflektierte Licht auf die Photovoltaikanlage zu leiten.

Des Weiteren wird eine Photovoltaik-Anordnung zur Erzeugung von elektrischem Strom aus Licht vorgeschlagen, welche aufweist:
- eine Photovoltaikanlage mit einer Vielzahl von Photovoltaikmodulen, und
- eine Anzahl M von Leitspiegeln, welche derart angeordnet sind, um Licht auf die Photovoltaikanlage zu leiten, wobei der jeweilige Leitspiegel eine Vielzahl parallel angeordneter Lamellen mit reflektierender Oberfläche aufweist, welche drehbar in einem Rahmen gelagert sind, wobei die drehbar gelagerten Lamellen dazu eingerichtet sind, eine vorbestimmten Spiegelform, insbesondere einen Hohlspiegel, auszubilden.

Ein Vorteil der vorliegenden Erfindung liegt darin, dass die großflächigen Reflektoren dazu eingerichtet sind, die auf die Photovoltaikanlage einfallende Lichtmenge durch Umleitung und begrenzte Konzentration deutlich zu erhöhen.

Damit kann entsprechend mehr elektrischer Strom generiert werden, so dass die Effizienz der Photovoltaikanlage deutlich gesteigert wird. Insgesamt wird die Effizienz einer Photovoltaik-Anlage erfindungsgemäß durch preisgünstige Reflektoren und/oder Spiegel auf kostengünstige Weise verbessert. Die großflächigen Reflektoren weisen eine reflektierende Oberfläche zur Reflexion des auf die Reflektoren einfallenden Lichtes auf die Photovoltaikanlage oder auf den oder die Leitspiegel auf.

Die Reflektoren sind insbesondere parallel oder unter einem spitzen Winkel zu den Photovoltaikmodulen ausgerichtet. Die Reflektoren können teilweise auch das einfallende Licht in einem stumpfen Winkel direkt auf die Photovoltaikmodule der Photovoltaikanlage leiten. Teilweise kann das einfallende Licht auch in einem spitzen Winkel reflektiert werden.

Um die Photovoltaikanlage vor einer Beschädigung durch eine zu hohe Lichtintensität des auf die Photovoltaikanlage einfallenden Lichtes zu schützen, sind die Reflektoren und/oder die Leitspiegel derart angeordnet und ausgebildet, dass sie nur einen vorbestimmten Prozentsatz des einfallenden Lichtes zur Begrenzung der Lichtintensität auf die Photovoltaikanlage lenken.

Der vorbestimmte Prozentsatz liegt beispielsweise zwischen 20 und 75%, bevorzugt zwischen 20 und 50%, besonders bevorzugt zwischen 25 und 40%.

Die Reflektoren sind insbesondere als ein preiswertes System ausgebildet, welches eine automatische Herstellung in großen Stückzahlen ermöglicht. Ein Beispiel für ein solches preiswertes System ist eine Plane oder ein Stoff mit einer reflektierenden Oberfläche. Dabei haben die Reflektoren folglich ein geringes Gewicht und ermöglichen eine flexible und sehr einfache Installation. Weiter ist die Aufstellung der Reflektoren insbesondere reversibel, ohne eine feste Verbindung zum Boden, so dass in der Regel keine Baugenehmigungen benötigt werden. Aufgrund der einfachen Konstruktion der Reflektoren ist auch eine einfache mechanische Ausrichtung, Korrigierbarkeit und Nachführung zur Einstellung der optimalen Position und Neigung der Reflektoren möglich. Insbesondere sind die Reflektoren korrosionsbeständig, wind- und wetterstabil ausgebildet.

Die Leitspiegel sind vorzugsweise kleinere, flexibel verstellbare Spiegel, welche zu den Photovoltaikmodulen der Photovoltaikanlage gegenüberstehend angeordnet sind. Durch die Photovoltaik-Anordnung der Reflektoren und/oder der Spiegel ist es möglich, Verschattungen durch Bäume oder andere Gegenstände, wie Gebäude, auf die Photovoltaikanlage auszugleichen.

Weiter werden Dach- und Fassadenflächen für die Aufstellung von Photovoltaikanlagen effizient und wirtschaftlich möglich, welche ohne zusätzliche Spiegel oder Reflektoren ungeeignet wären. Dies gilt im Besonderen für Fassadenflächen, bei welchen der Winkel zur Sonne regelmäßig ungünstig ist.

Vorteilhafte Ausgestaltungen und Weiterbildungen der Erfindung ergeben sich aus den Unteransprüchen sowie der Beschreibung unter Bezugnahme auf die Zeichnungen.

Gemäß einer bevorzugten Weiterbildung ist die Fläche des jeweiligen Reflektors zumindest um einen Faktor F größer als die bestimmte Fläche der Photovoltaikanlage. Der Faktor F liegt insbesondere zwischen 1 und 6, bevorzugt zwischen 1 und 3.

Gemäß einer weiteren bevorzugten Weiterbildung ist die Anzahl N der Reflektoren in einer trapezförmigen Anordnung um die Photovoltaikanlage angeordnet ist. Infolge der Verwendung der trapezförmigen Anordnung der Reflektoren können herkömmliche Nachführsysteme im Freiraum-Betrieb ersetzt werden. Durch diese Ersetzung der herkömmlichen Nachführsysteme ergibt sich ein weiterer Kostenvorteil.

Gemäß einer weiteren bevorzugten Weiterbildung hat der jeweilige großflächige Reflektor eine Plane aus einem Kunststoff oder einem Stoff mit einer reflektierenden Oberfläche.

Gemäß einer weiteren bevorzugten Weiterbildung hat die jeweilige Plane eine Mehrzahl von Schlitzen, die dazu eingerichtet sind, Wasser abfließen zu lassen und Wind durchzulassen.

Gemäß einer weiteren bevorzugten Weiterbildung ist eine jeweilige Befestigungs-Einrichtung zum reversiblen Befestigen der jeweiligen Plane oder des Stoffes am Boden oder einer ortsfesten Einrichtung vorgesehen. Die Plane aus Kunststoff oder der Stoff sind vorzugsweise als ein Segel ausgebildet. Die Befestigungseinrichtung weist insbesondere zumindest eine Sollbruch-Einrichtung auf, die dazu eingerichtet ist, bei sehr starken Stürmen oder Winden zu reißen, um eine Beschädigung durch das Segel zu verhindern. Die Sollbruch-Einrichtung ist insbesondere durch Schüre, Drähte oder Klammern ausgebildet, welche das Segel mit der Befestigungs-Einrichtung koppeln.

Gemäß einer weiteren bevorzugten Weiterbildung hat die Befestigungseinrichtung eine Höheneinstelleinrichtung zum Einstellen der Höhe der jeweiligen Plane relativ zum Boden.

Gemäß einer weiteren bevorzugten Weiterbildung ist die Höheneinstelleinrichtung dazu eingerichtet, die jeweilige Plane mit einem vorbestimmten Winkel und/oder mit einer vorbestimmten Krümmung anzuordnen.

Gemäß einer weiteren bevorzugten Weiterbildung hat die Befestigungseinrichtung eine Nachführeinrichtung, welche dazu eingerichtet ist, die jeweilige Plane der optimalen Lichteinstrahlung auf die Plane nachzuführen.

Gemäß einer weiteren bevorzugten Weiterbildung ist zumindest eine Lichtsensoreinrichtung an oder in der Photovoltaikanlage angeordnet. Die Lichtsensoreinrichtung ist dazu eingerichtet, ein Detektionssignal in Abhängigkeit des auf die Photovoltaikanlage einfallenden Lichtes, insbesondere in Abhängigkeit der auf die Photovoltaikanlage einfallenden Lichtmenge, bereitzustellen.

Gemäß einer weiteren bevorzugten Weiterbildung ist eine Steuereinrichtung zum Steuern der Nachführeinrichtung und/oder der Höheneinstelleinrichtung in Abhängigkeit des Detektionssignals der zumindest einen Lichtsensoreinrichtung vorgesehen.

Gemäß einer weiteren bevorzugten Weiterbildung hat die Befestigungseinrichtung Stützen, insbesondere Metallstützen, zum Verankern der jeweiligen Plane im Boden.

Gemäß einer weiteren bevorzugten Weiterbildung liegt die Anzahl N der Reflektoren zwischen 2 und 16, bevorzugt zwischen 4 und 12, besonders bevorzugt zwischen 4 und 6 liegt.

Gemäß einer weiteren bevorzugten Weiterbildung liegt die Anzahl M der Leitspiegel zwischen 1 und 6 liegt, bevorzugt zwischen 1 und 3. Besonders bevorzugt ist die Anzahl M gleich 2.

Gemäß einer weiteren bevorzugten Weiterbildung ist der jeweilige Reflektor dazu eingerichtet, einen ersten Teil des einfallenden Lichtes auf zumindest einen der Leitspiegel und einen zweiten Teil des einfallenden Lichtes direkt auf die Photovoltaikanlage gebündelt zu reflektieren.

Insbesondere hat die Photovoltaikanlage eine bestimmte erste Fläche (F1), die N Reflektoren haben eine bestimmte zweite Fläche (F2) und die M Leitspiegel haben eine bestimmte dritte Fläche (F3), wobei die zweite Fläche groß gegenüber der ersten Fläche (F2 > F1) und groß gegenüber der dritten Fläche ist (F2 > F3) .

Gemäß einer weiteren bevorzugten Weiterbildung hat der jeweilige Leitspiegel eine Vielzahl parallel angeordneter

Lamellen mit reflektierender Oberfläche. Vorzugsweise sind die Lamellen in einem Rahmen drehbar gelagert.

Gemäß einer weiteren bevorzugten Weiterbildung sind die drehbar gelagerten Lamellen dazu eingerichtet, eine vorbestimmte Spiegelform auszubilden. Die vorbestimmte Spiegelform ist beispielweise die eines Hohlspiegels.

Gemäß einer weiteren bevorzugten Weiterbildung ist eine jeweilige Befestigungsvorrichtung zum reversiblen Befestigen des jeweiligen Leitspiegels am Boden oder an einer ortsfesten Einrichtung vorgesehen, an welcher der Rahmen des jeweiligen Leitspiegels drehbar gelagert ist.

Gemäß einer weiteren bevorzugten Weiterbildung ist eine Steuervorrichtung zum Steuern der Ausrichtung der drehbar gelagerten Lamellen und zum Steuern der Ausbildung der vorbestimmten Spiegelform vorgesehen.

Gemäß einer weiteren bevorzugten Weiterbildung hat die Befestigungsvorrichtung eine Höheneinstellvorrichtung zum Einstellen der Höhe des jeweiligen Leitspiegels relativ zum Boden.

Gemäß einer weiteren bevorzugten Weiterbildung hat die Befestigungsvorrichtung eine Nachführvorrichtung zur Einstellung der Neigung und/oder des Drehwinkels des jeweiligen Leitspiegels. Insbesondere ist die Nachführvorrichtung dazu eingerichtet, den jeweiligen Leitspiegel der optimalen Lichteinstrahlung auf den Leitspiegel nachzuführen.

Gemäß einer weiteren bevorzugten Weiterbildung ist eine Steuervorrichtung zum Steuern der Nachführvorrichtung und/oder der Höheneinstellvorrichtung in Abhängigkeit des Detektionssignals vorgesehen.

Gemäß einer weiteren bevorzugten Weiterbildung sind die Lamellen mittels eines Extrusionsverfahrens aus Kunststoff hergestellt. Insbesondere ist eine Seite der jeweiligen Lamelle mit einer reflektierenden metallisierten Folie beschichtet.

Die Erfindung wird nachfolgend anhand der in den schematischen Figuren angegebenen Ausführungsbeispiele näher erläutert. Es zeigen:
- Fig. 1: ein schematisches Blockschaltbild eines ersten Ausführungsbeispiels einer erfindungsgemäßen Photovoltaik-Anordnung zur Erzeugung von elektrischem Strom aus Licht;
- Fig. 2: ein schematisches Blockschaltbild eines ersten Ausführungsbeispiels eines Reflektors der erfindungsgemäßen Photovoltaik-Anordnung zur Erzeugung von elektrischem Strom aus Licht;
- Fig. 3: ein schematisches Blockschaltbild eines zweiten Ausführungsbeispiels eines Reflektors der erfindungsgemäßen Photovoltaik-Anordnung zur Erzeugung von elektrischem Strom aus Licht;
- Fig. 4a,4b: schematische Blockschaltbilder eines dritten Ausführungsbeispiels eines Reflektors der erfindungsgemäßen Photovoltaik-Anordnung zur Erzeugung von elektrischem Strom aus Licht;
- Fig. 5a,5b: schematische Blockschaltbilder eines vierten Ausführungsbeispiels eines Reflektors der erfindungsgemäßen Photovoltaik-Anordnung zur Erzeugung von elektrischem Strom aus Licht;
- Fig. 6: ein schematisches Blockschaltbild eines zweiten Ausführungsbeispiels einer erfindungsgemäßen Photovoltaik-Anordnung zur Erzeugung von elektrischem Strom aus Licht;
- Fig. 7: ein schematisches Blockschaltbild eines dritten Ausführungsbeispiels einer erfindungsgemäßen Photovoltaik-Anordnung zur Erzeugung von elektrischem Strom aus Licht;
- Fig. 8: ein schematisches Blockschaltbild des dritten Ausführungsbeispiels der erfindungsgemäßen Photovoltaik-Anordnung nach Fig. 7 mit einer Darstellung einer beispielhaften Lichteinstrahlung;
- Fig. 9: ein schematisches Blockschaltbild eines vierten Ausführungsbeispiels einer erfindungsgemäßen Photovoltaik-Anordnung zur Erzeugung von elektrischem Strom aus Licht;
- Fig. 10a,10b: schematische Blockschaltbilder eines Ausführungsbeispiels eines Leitspiegels der erfindungsgemäßen Photovoltaik-Anordnung zur Erzeugung von elektrischem Strom aus Licht;
- Fig. 11a-11c: schematische Schnittansichten eines Ausführungsbeispiels einer Lamelle des Leitspiegels nach den Fig. 10a und 10b; und
- Fig. 12: schematische Schnittansichten eines Ausführungsbeispiels einer Koppeleinrichtung zum Koppeln der Lamelle mit einem Rahmen des Leitspiegels nach den Fig. 10a und 10b.

In allen Figuren sind gleiche bzw. funktionsgleiche Mittel und Einrichtungen - sofern nichts anderes angegeben - mit denselben Bezugszeichen versehen.

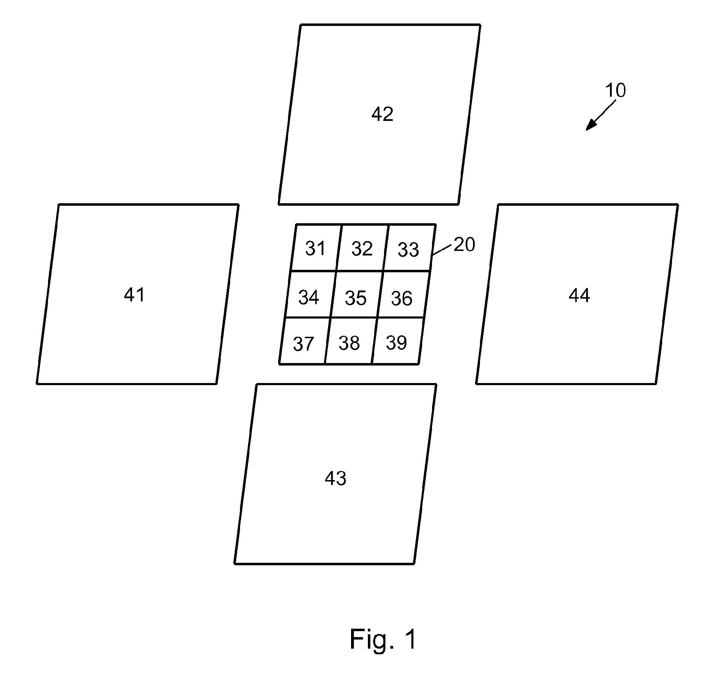

In Fig. 1 ist ein schematisches Blockschaltbild eines ersten Ausführungsbeispiels einer erfindungsgemäßen Photovoltaik-Anordnung 10 zur Erzeugung von elektrischem Strom aus Licht dargestellt.

Die Photovoltaik-Anordnung 10 oder das System 10 hat eine Photovoltaikanlage 20 mit einer vorbestimmten Fläche. Die Photovoltaikanlage 20 umfasst eine Vielzahl von Photovoltaikmodulen 31-39. Ohne Einschränkung der Allgemeinheit sind in Fig. 1 neun Photovoltaikmodule 31-39 dargestellt. Selbstverständlich kann eine Photovoltaikanlage 20 eine größere Anzahl von Photovoltaikmodulen 31-39 aufweisen, beispielsweise einige Hundert oder auch einige Tausend.

Weiter weist die Photovoltaik-Anordnung 10 eine Anzahl N von Reflektoren 41-44 auf. Ohne Einschränkung der Allgemeinheit sind in Fig. 1 vier Reflektoren 41-44 dargestellt (N = 4).

Der jeweilige Reflektor 41-44 ist großflächig gegenüber der Fläche der Photovoltaikanlage 20.

Weiter ist der jeweilige Reflektor 41-44 dazu eingerichtet, zumindest einen Teil eines auf den jeweiligen Reflektor 41-44 einfallenden Lichtes auf die Photovoltaikanlage 20 zu leiten oder zu reflektieren.

Die Fläche des jeweiligen Reflektors 41-44 ist zumindest um einen Faktor F größer als die bestimmte Fläche der Photovoltaikanlage 20. Der Faktor F liegt beispielsweise zwischen 2 und 10, bevorzugt zwischen 3 und 8, besonders bevorzugt zwischen 4 und 6. Die Anzahl N der Reflektoren 41-44 ist insbesondere in einer trapezförmigen Anordnung um die Photovoltaikanlage 20 angeordnet. Die trapezförmige Photovoltaik-Anordnung ist beispielsweise als ein gleichschenkliges Trapez ausgebildet. Somit wird hier der bekannte Effekt eines Lichtstrahlers, zum Beispiel eines Büro-Strahlers, umgekehrt.

Der jeweilige großflächige Reflektor 41-44 ist beispielsweise als eine Plane aus einem Kunststoff ausgebildet. Alternativ kann der jeweilige großflächige Reflektor 41-44 aus einem Stoff mit einer reflektierenden Oberfläche ausgebildet sein.

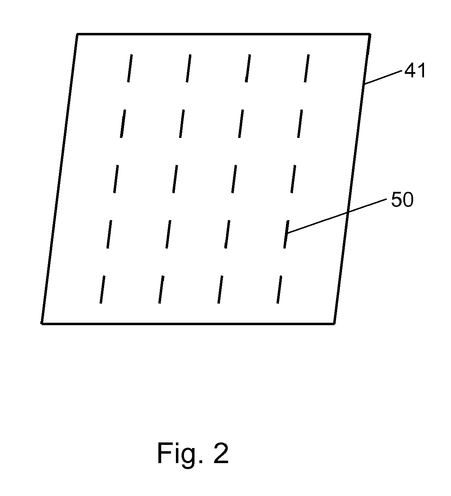

Fig. 2 zeigt ein schematisches Blockschaltbild eines ersten Ausführungsbeispiels eines Reflektors 41 der erfindungsgemäßen Photovoltaik-Anordnung 10 nach Fig. 1. Der jeweilige Reflektor 41 ist beispielsweise als Plane 41 ausgebildet und hat eine Mehrzahl von Schlitzen 50. Die Schlitze 50 sind dazu eingerichtet, Wasser abfließen zu lassen und Wind hindurchzulassen. Damit schützen die Schlitze 50 die Plane 41 vor Beschädigungen durch Wind oder Regen.

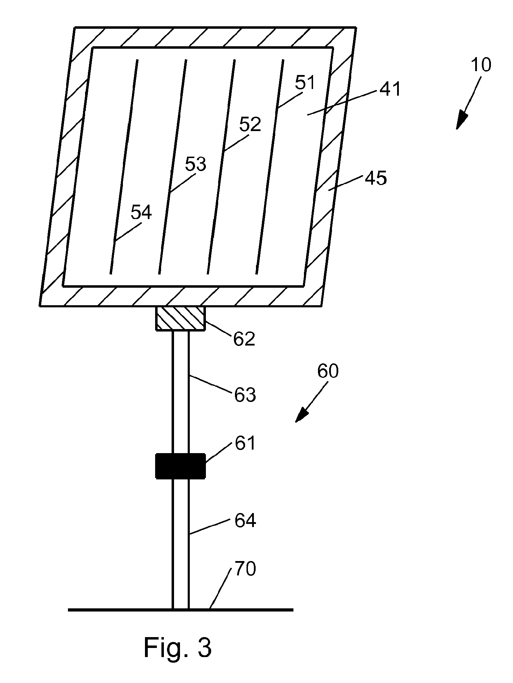

In Fig. 3 ist ein schematisches Blockschaltbild eines zweiten Ausführungsbeispiels eines Reflektors 41 der erfindungsgemäßen Photovoltaik-Anordnung 10 zur Erzeugung von elektrischem Strom aus Licht dargestellt. Dabei umfasst die Photovoltaik-Anordnung 10 den Reflektor 41 gemäß Fig. 2 mit den Schlitzen 50. Der Reflektor 41, der beispielsweise als Plane ausgebildet ist, ist in einem Befestigungsrahmen 45 befestigt. An dem Befestigungsrahmen 45 ist eine Nachführeinrichtung 62 angeordnet. Die Nachführeinrichtung 62 ist dazu eingerichtet, die jeweilige Plane 41 der optimalen Lichteinstrahlung nachzuführen. Beispielsweise weist die Nachführeinrichtung 62 einen Innensechskant zum Eingriff eines Vielecks eines Stabes auf.

Weiter ist eine Höheneinstellung 61 vorgesehen. Die Höheneinstelleinrichtung 61 und die Nachführeinrichtung 62 bilden eine Befestigungseinrichtung 60 zum Befestigen der jeweiligen Plane 41 am Boden 70 oder an einer ortsfesten Einrichtung aus.

Die Höheneinstelleinrichtung 61 ist dazu eingerichtet, die Höhe der jeweiligen Plane 41 relativ zum Boden 70 einzustellen. Weiter kann die Höheneinstelleinrichtung 61 dazu eingerichtet werden, die jeweilige Plane 41 mit einem vorbestimmten Winkel und/oder mit einer vorbestimmten Krümmung anzuordnen.

Insbesondere weist die Befestigungseinrichtung 60 Stützen, insbesondere Metallstützen, zum Verankern der jeweiligen Plane 41 im Boden auf.

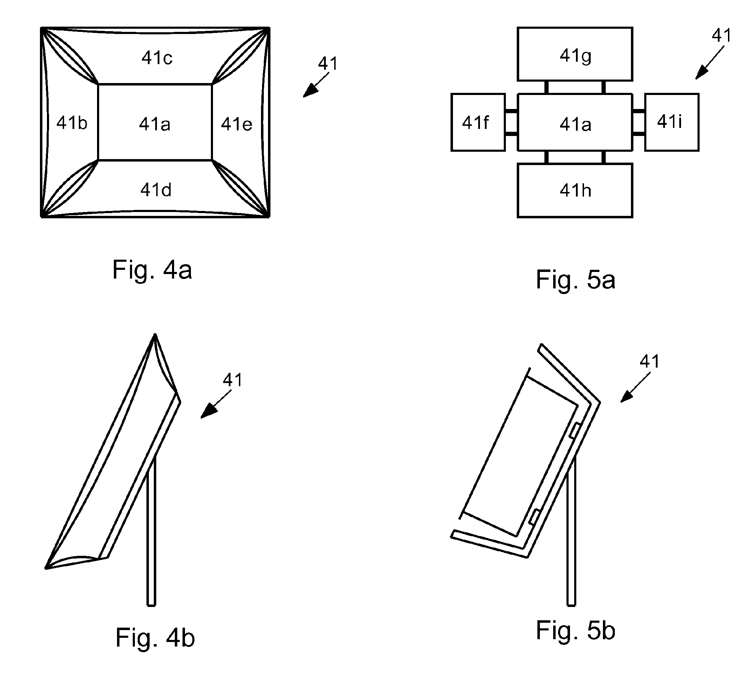

Die Fig. 4a und 4b zeigen schematische Blockschaltbilder eines dritten Ausführungsbeispiels eines Reflektors 41 der erfindungsgemäßen Photovoltaik-Anordnung 10 zum Erzeugen von elektrischem Strom aus Licht. Gemäß der Fig. 4a und 4b hat der Reflektor 41 eine Basisfläche 41a und an den Seiten der Basisfläche 41a angeordnete Winkelflächen 41a-41d. Dabei sind die Winkelflächen 41a-41d, insbesondere in einem jeweiligen einstellbaren Winkel, gegenüber der Basisfläche 41a einstellbar.

Weiter zeigen die Fig. 5a und 5b schematische Blockschaltbilder eines vierten Ausführungsbeispiels eines Reflektors 41 der erfindungsgemäßen Photovoltaik-Anordnung 10 zur Erzeugung von elektrischem Strom aus Licht.

Gemäß der Fig. 5a und 5b hat der Reflektor 41 eine Basisfläche 41a und eine Mehrzahl an den Seiten der Basisfläche 41a drehbar angeordnete Drehflächen 41f-41i. Vorzugsweise ist an jeder Seite der Basisfläche 41a eine jeweilige Drehfläche 41f-41i angeordnet. Die Drehflächen 41f-41i sind mit einem einstellbaren Drehwinkel gegenüber der Basisfläche 41a anordenbar. Diese Einstellung erfolgt vorzugsweise manuell.

Die Ausführungsbeispiele des Reflektors 41 gemäß der Fig. 4a, 4b, 5a und 5b haben den gemeinsamen Vorteil, dass sich die Reflektoren 41 besonders für am Boden 70 montierte Anlagen und für Anlagen genügend großer Dachflächen eignen.

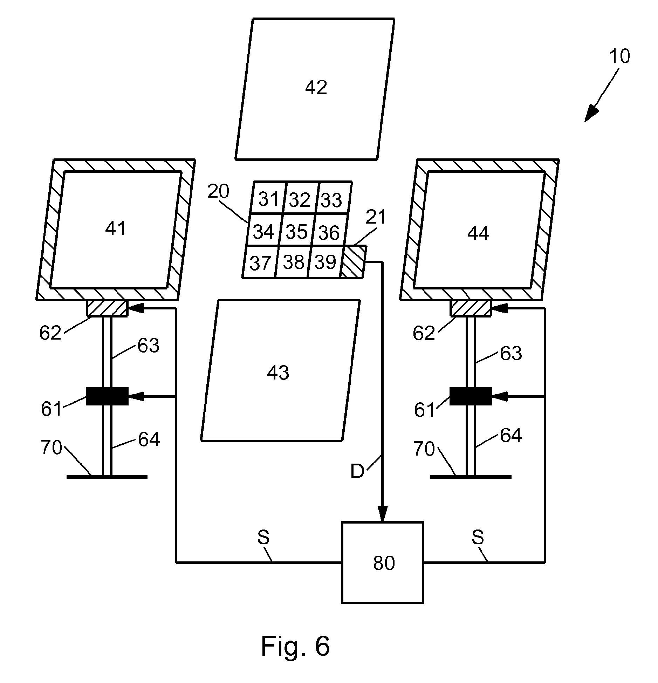

Fig. 6 zeigt ein schematisches Blockschaltbild eines zweiten Ausführungsbeispiels einer erfindungsgemäßen Photovoltaik-Anordnung 10 zur Erzeugung von elektrischem Strom aus Licht. Das zweite Ausführungsbeispiel gemäß Fig. 6 umfasst das erste Ausführungsbeispiel gemäß Fig. 1. Weiter hat die Photovoltaik-Anordnung 10 gemäß Fig. 6 zwei Reflektoren 41, 44, welche gemäß dem Ausführungsbeispiel nach Fig. 3 ausgebildet sind. Weiterhin sind die Reflektoren 42, 43 als ortsfeste Reflektoren ausgebildet, die beispielsweise auf einem Dach eines Hauses oder eines Gebäudes angeordnet sind.

Ferner umfasst die Photovoltaik-Anordnung 10 nach Fig. 6 zumindest eine Lichtsensoreinrichtung 21. Die Lichtsensoreinrichtung 21 ist an oder in der Photovoltaikanlage 10 angeordnet. Ohne Einschränkung der Allgemeinheit ist die Lichtsensoreinrichtung 21 nach Fig. 6 an der Photovoltaikanlage 20 angeordnet. Die Lichtsensoreinrichtung 21 generiert ein Detektionssignal D in Abhängigkeit des auf die Photovoltaikanlage 20 einfallenden Lichtes, insbesondere in Abhängigkeit der auf die Photovoltaikanlage 20 einfallenden Lichtmenge.

Des Weiteren umfasst die Photovoltaik-Anordnung 10 nach Fig. 6 eine Steuereinrichtung 80. Die Steuereinrichtung 80 ist zumindest dazu eingerichtet, die Nachführeinrichtung 62 und/oder die Höheneinstelleinrichtung 61 in Abhängigkeit des Detektionssignals D der zumindest einen Lichtsensoreinrichtung 21 zu steuern.

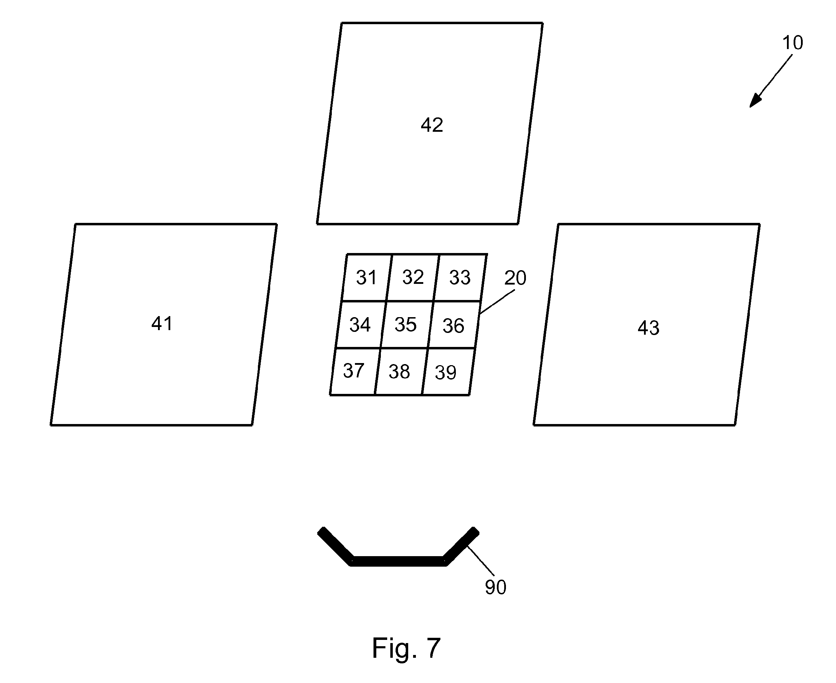

In Fig. 7 ist ein schematisches Blockschaltbild eines dritten Ausführungsbeispiels einer erfindungsgemäßen Photovoltaik-Anordnung 10 zur Erzeugung von elektrischem Strom aus Licht dargestellt. Die Photovoltaik-Anordnung 10 nach Fig. 7 umfasst eine Anzahl N von Reflektoren 41-43, welche dazu eingerichtet sind, zumindest einen Teil des auf die Anzahl N von Reflektoren 41-43 einfallenden Lichtes auf eine Anzahl M von Leitspiegeln 90 zu reflektieren. Ohne Einschränkung der Allgemeinheit sind in Fig. 7 drei Reflektoren dargestellt (N = 3).

Weiter umfasst die Photovoltaik-Anordnung 10 die Anzahl M von Leitspiegeln 90. Die M Leitspiegel 90 sind derart angeordnet, dass sie das von der Anzahl N der Reflektoren 41-43 reflektierte Licht auf die Photovoltaikanlage 20 leiten. Ohne Einschränkung der Allgemeinheit ist in Fig. 7 ein einziger Leitspiegel 90 vorgesehen (M = 1).

vorzugsweise ist die Anzahl M der Leitspiegel 90 zwischen 1 und 6, bevorzugt zwischen 1 und 3, besonders bevorzugt 2. Demgegenüber ist die Anzahl N der Reflektoren bevorzugt zwischen 2 und 16, besonders bevorzugt zwischen 4 und 12 oder besonders bevorzugt zwischen 4 und 6.

Die Photovoltaikanlage 20 hat eine bestimmte erste Fläche, wobei die N Reflektoren 41-43 jeweils eine bestimmte zweite Fläche haben und die M Leitspiegel 90 jeweils eine bestimmte dritte Fläche haben. Dabei ist die zweite Fläche groß gegenüber der ersten Fläche und groß gegenüber der dritten Fläche.

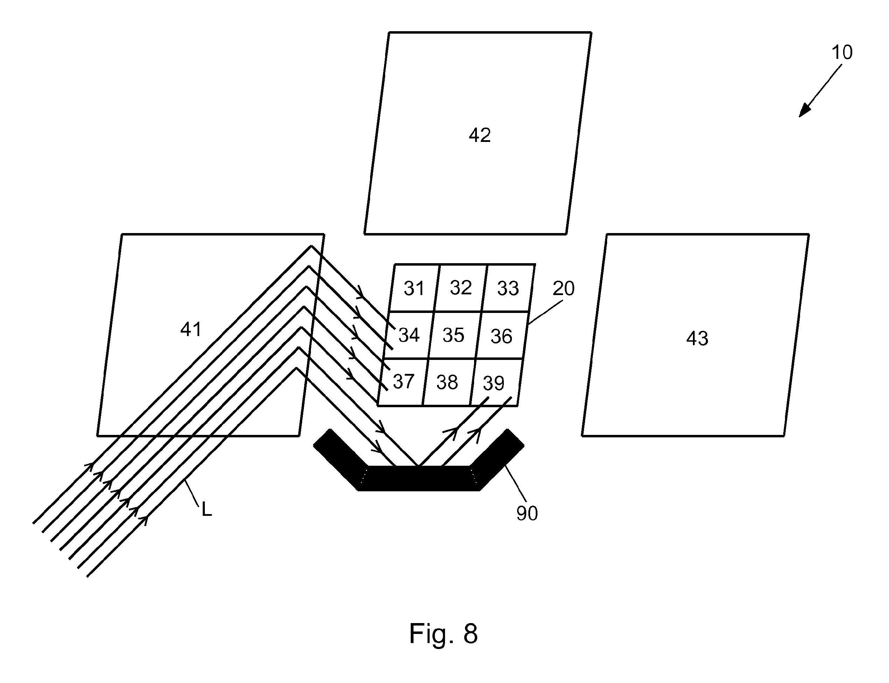

In Fig. 8 ist das schematische Blockschaltbild des dritten Ausführungsbeispiels der erfindungsgemäßen Photovoltaik-Anordnung 10 nach Fig. 7 mit einer Darstellung einer beispielhaften Lichteinstrahlung L dargestellt. Dabei zeigt Fig. 8, dass der jeweilige Reflektor 41-43 (nach dem Ausführungsbeispiel in Fig. 8 der Reflektor 41) dazu eingerichtet ist, einen ersten Teil des einfallenden Lichtes L auf zumindest einen der Leitspiegel 90 und einen zweiten Teil des einfallenden Lichtes L direkt auf die Photovoltaikanlage 20 gebündelt zu reflektieren.

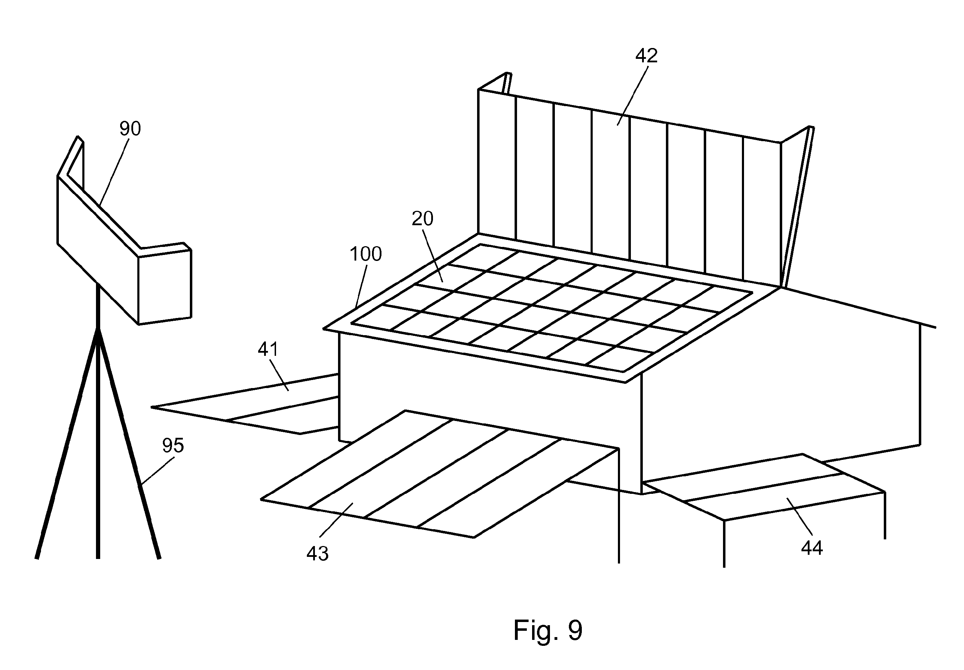

In Fig. 9 ist ein schematisches Blockschaltbild eines vierten Ausführungsbeispiels einer erfindungsgemäßen Photovoltaik-Anordnung 10 zur Erzeugung von elektrischem Strom aus Licht dargestellt. Das Ausführungsbeispiel nach Fig. 9 basiert auf dem Ausführungsbeispiel nach Fig. 7 und umfasst die Merkmale des Ausführungsbeispiels nach Fig. 7, die zur Vermeidung von Wiederholungen hier nicht nochmals ausführlich diskutiert werden. Weiterhin zeigt das Ausführungsbeispiel nach Fig. 9, dass eine Befestigungsvorrichtung 95 zum reversiblen Befestigen des Leitspiegels 90 am Boden 70 vorgesehen ist. Die Befestigungsvorrichtung 95 ist insbesondere derart eingerichtet, dass der Rahmen des jeweiligen Leitspiegels 90 drehbar gelagert ist.

Weiter weist die Befestigungsvorrichtung 95 vorzugsweise eine Höheneinstellvorrichtung (nicht gezeigt) zum Einstellen der Höhe des jeweiligen Leitspiegels 90 relativ zum Boden 70 auf. Des Weiteren hat die Befestigungsvorrichtung 95 vorzugsweise eine Nachführvorrichtung (nicht gezeigt) zur Einstellung der Neigung und/oder des Drehwinkels des jeweiligen Leitspiegels 90, welche dazu eingerichtet ist, den jeweiligen Leitspiegel 90 der optimalen Lichteinstrahlung nachzuführen.

Weiterhin ist vorzugsweise zumindest eine Lichtsensorvorrichtung 21 an oder in der Photovoltaikanlage 20 angeordnet, welche das Detektionssignal D in Abhängigkeit des auf die Photovoltaikanlage 20 einfallenden Lichtes bereitstellt. Vorzugsweise wird dieses Detektionssignal D von einer Steuervorrichtung zum Steuern der Nachführvorrichtung und/oder der Höheneinstellvorrichtung in Abhängigkeit des Detektionssignals genutzt. Insbesondere kann die Steuervorrichtung Teil der Steuereinrichtung 80 sein.

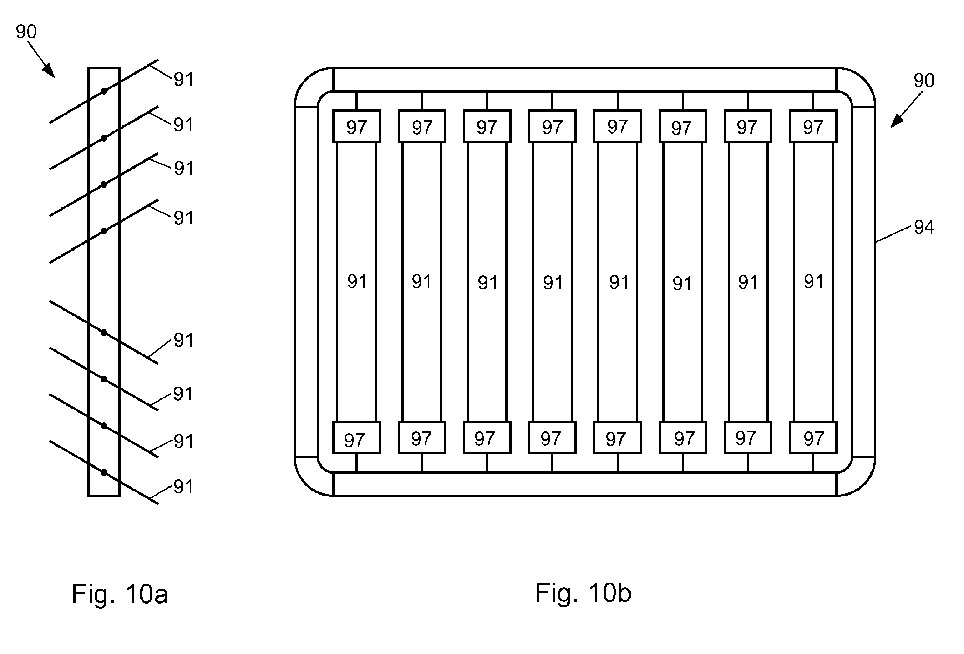

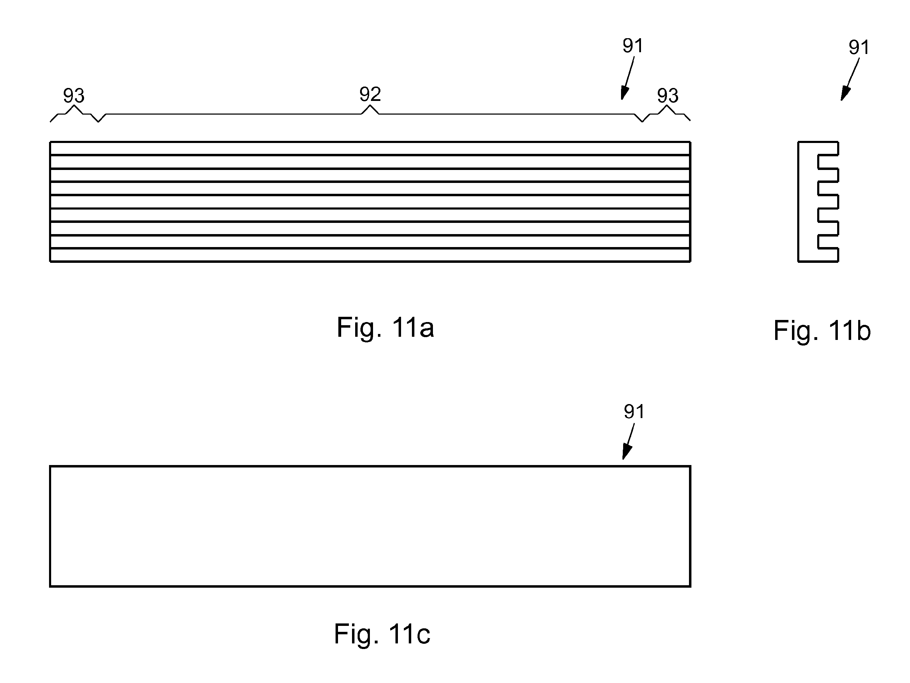

Die Fig. 10a und 10b zeigen schematische Blockschaltbilder eines Ausführungsbeispiels eines Leitspiegels 90 der erfindungsgemäßen Photovoltaik-Anordnung 10 zur Erzeugung von elektrischem Strom aus Licht. Der jeweilige Leitspiegel 90 hat eine Vielzahl parallel angeordneter Lamellen 91 mit reflektierender Oberfläche 92 (siehe dazu Fig. 11). Die Lamellen 91 sind drehbar in einem Rahmen 94 gelagert. Der Rahmen 94 ist vorzugsweise aus verklebten Kunststoffrohren hergestellt und hat ein Gewicht von weniger als 10 kg.

Vorzugsweise sind die drehbar gelagerten Lamellen 91 dazu eingerichtet, eine vorbestimmte Spiegelform, insbesondere einen Hohlspiegel, auszubilden. Zum Steuern der Ausbildung der vorbestimmten Spiegelform ist vorzugsweise eine Steuervorrichtung zum Steuern der Ausrichtung der drehbar gelagerten Lamellen 91 vorgesehen. Die Steuervorrichtung ist - wie oben ausgeführt - insbesondere Teil der Steuereinrichtung 80 und bildet ihre Steuerfunktion in Abhängigkeit des Detektionssignals D ab. Zur Kopplung der jeweiligen Lamelle 91 mit dem Rahmen 94 sind jeweils zwei Koppeleinrichtungen 97 vorgesehen. Fig. 10a illustriert die Möglichkeit der Ausbildung eines Hohlspiegels durch die Lamellen 91.

Die Fig. 11a -11c zeigen schematische Schnittansichten eines Ausführungsbeispiels einer Lamelle 91 des Leitspiegels 90 nach den Fig. 10a und 10b. Dabei zeigt die Fig. 11a die Vorderseite, die Fig. 11b den Querschnitt und die Fig.11c die Rückseite der Lamelle 91. Gemäß Fig. 11a ist der wesentliche Teil der Oberfläche der Lamelle 91 als reflektierende Oberfläche 92 ausgebildet. Lediglich die Randbereiche 93 sind als nicht-reflektierende Oberfläche 93 ausgebildet. Die Randbereiche 93 werden zur Kopplung mit den Koppeleinrichtungen 97 verwendet.

Im Detail zeigt Fig. 11b eine Querschnittsansicht der Lamelle 91. Gemäß Fig. 11b hat die Lamelle 91 eine gerippte Struktur zur Erhöhung der Stabilität der Lamelle 91.

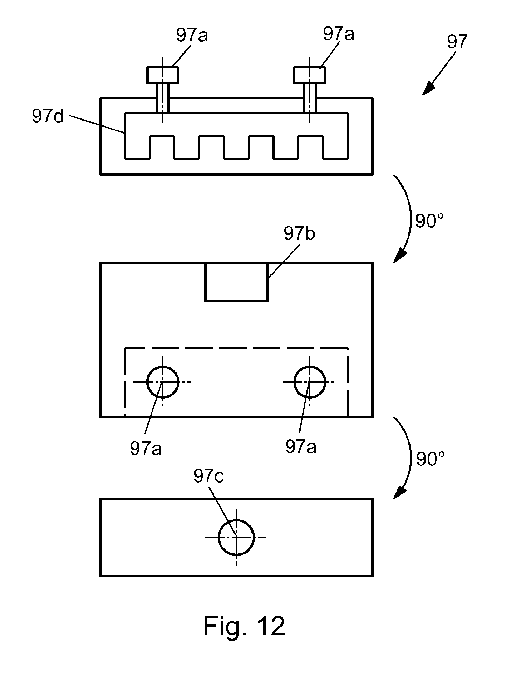

Weiterhin zeigt Fig. 12 schematische Schnittansichten eines Ausführungsbeispiels einer Koppeleinrichtung 97 zum Koppeln der Lamelle 91 mit dem Rahmen 94 des Leitspiegels 90 nach den Fig. 10a und 10b. Die Koppeleinrichtung 97 hat eine Aufnahmeeinrichtung 97d zur Aufnahme der jeweiligen Lamelle 91. Die Aufnahmeeinrichtung 97d ist hinsichtlich der gerippten Struktur als ein Negativ der Lamelle 91 ausgebildet. Weiter weist die Koppeleinrichtung 97 eine Eingriffseinrichtung 97b zum manuellen Drehen der Koppeleinrichtung 97 auf. Insbesondere hat die Eingriffseinrichtung 97b einen Innensechskant.

Des Weiteren hat die Koppeleinrichtung 97 eine Gewindehülse 97c für einen Gewindestift zur Befestigung der Koppeleinrichtung 97.

Aufgrund dieser Photovoltaik-Anordnung mit der Koppeleinrichtung 97 kann sich die Lamelle 91 bei Wind so stark verbiegen, dass sie aus der Koppeleinrichtung 97 rutscht und dem Wind nachgibt. Somit wird eine Beschädigung der Lamelle 91 verhindert.

Obwohl die vorliegende Erfindung vorstehend anhand der bevorzugten Ausführungsbeispiele beschrieben wurde, ist sie darauf nicht beschränkt, sondern auf vielfältige Art und Weise modifizierbar.

### Bezugszeichenliste

- 10: Photovoltaik-Anordnung
- 20: Photovoltaikanlage
- 21: Lichtsensorvorrichtung
- 31-39: Photovoltaikmodul
- 41-44: Reflektor
- 41a: Basisfläche
- 41b-41e: Winkelfläche
- 41f-41i: Drehfläche
- 45: Befestigungsrahmen
- 50: Schlitz
- 60: Befestigungseinrichtung
- 61: Höheneinstelleinrichtung
- 62: Nachführeinrichtung
- 63, 64: Stützen
- 70: Boden
- 80: Steuereinrichtung
- 90: Leitspiegel
- 91: Lamelle
- 92: reflektierende Oberfläche
- 93: nicht-reflektierende Oberfläche
- 94: Rahmen
- 95: Befestigungsvorrichtung
- 97: Koppeleinrichtung
- 97a: Schraube
- 97b: Eingriffseinrichtung
- 97c: Gewindehülse
- 97d: Aufnahmeeinrichtung
- 100: Dach
- D: Detektionssignal
- S: Steuersignal

## Patentansprüche

1. Photovoltaik-Anordnung (10) zur Erzeugung von elektrischem Strom aus Licht, mit:
a) einer Photovoltaikanlage (20) mit einer Vielzahl von Photovoltaikmodulen (31-39);
b) einer Anzahl N von Reflektoren (41-43), welche dazu eingerichtet sind, zumindest einen Teil des auf die Anzahl N von Reflektoren (41-43) einfallenden Lichtes auf eine Anzahl M von Leitspiegeln (90) zu reflektieren; und
c) die Anzahl M von Leitspiegeln (90), welche derart angeordnet sind, um das von der Anzahl N der Reflektoren (41-43) reflektierte Licht auf die Photovoltaikanlage (20) zu leiten.

2. Photovoltaik-Anordnung nach Anspruch 1,
**dadurch gekennzeichnet,**
**dass** die Anzahl N der Reflektoren (41-43) zwischen 2 und 16, bevorzugt zwischen 4 und 12, besonders bevorzugt zwischen 4 und 6 liegt, und/oder,
**dass** die Anzahl M der Leitspiegel (90) zwischen 1 und 6 liegt, bevorzugt zwischen 1 und 3 liegt, besonders bevorzugt 2 ist.

3. Photovoltaik-Anordnung nach Anspruch 1 oder 2,
**dadurch gekennzeichnet,**
**dass** der jeweilige Reflektor (41-43) dazu eingerichtet ist, einen ersten Teil des einfallenden Lichtes auf zumindest einen der Leitspiegel (90) und einen zweiten Teil des einfallenden Lichtes direkt auf die Photovoltaikanlage (20) gebündelt zu reflektieren; und/oder
**dass** die Photovoltaikanlage (20) eine bestimmte erste Fläche hat, die N Reflektoren (41-43) eine bestimmte zweite Fläche haben und die M Leitspiegel (90) eine bestimmte dritte Fläche haben, wobei die zweite Fläche groß gegenüber der ersten Fläche und groß gegenüber der dritten Fläche ist; und/oder dass der jeweilige Leitspiegel (90) eine Vielzahl parallel angeordneter Lamellen (91) mit reflektierender Oberfläche (92) aufweist, welche drehbar in einem Rahmen (94) gelagert sind.

4. Photovoltaik-Anordnung nach Anspruch 3,
**dadurch gekennzeichnet,**
**dass** die drehbar gelagerten Lamellen (91) dazu eingerichtet sind, eine vorbestimmte Spiegelform, insbesondere einen Hohlspiegel, auszubilden,
wobei vorzugsweise eine Steuervorrichtung (80) zum Steuern der Ausrichtung der drehbar gelagerten Lamellen (91) und zum Steuern der Ausbildung der vorbestimmten Spiegelform vorgesehen ist.

5. Photovoltaik-Anordnung nach Anspruch 3 oder 4,
**dadurch gekennzeichnet,**
**dass** eine jeweilige Befestigungsvorrichtung (95) zum reversiblen Befestigen des jeweiligen Leitspiegels (90) am Boden (70) oder an einer ortsfesten Einrichtung vorgesehen ist, an welcher der Rahmen (94) des jeweiligen Leitspiegels (90) drehbar gelagert ist,
wobei die Befestigungsvorrichtung (95) vorzugsweise eine Höheneinstellvorrichtung zum Einstellen der Höhe des jeweiligen Leitspiegels (90) relativ zum Boden (70) und eine Nachführvorrichtung zur Einstellung der Neigung und/oder des Drehwinkels des jeweiligen Leitspiegels (90) aufweist, die dazu eingerichtet ist, den jeweiligen Leitspiegel (90) der optimalen Lichteinstrahlung nachzuführen; und/oder dass der Reflektor (41-44) als ein Segel (41) ausgebildet ist und die Befestigungs-Einrichtung (95) eine Sollbruch-Einrichtung aufweist, welche dazu eingerichtet ist, bei starken Winden zu reißen, um eine durch das Segel (41) verursachten Schaden zu verhindern.

6. Photovoltaik-Anordnung nach Anspruch 5,
**dadurch gekennzeichnet,**
**dass** zumindest eine Lichtsensorvorrichtung (21) an oder in der Photovoltaikanlage (20) angeordnet ist, welche ein Detektionssignal (D) in Abhängigkeit des auf die Photovoltaikanlage (20) einfallenden Lichtes, insbesondere in Abhängigkeit der auf die Photovoltaikanlage (20) einfallenden Lichtmenge, bereitstellt,
wobei vorzugsweise eine Steuervorrichtung (80) zum Steuern der Nachführvorrichtung und/oder der Höheneinstellvorrichtung in Abhängigkeit des Detektionssignals (D) der zumindest einen Lichtsensorvorrichtung (21) vorgesehen ist.

7. Photovoltaik-Anordnung nach einem der Ansprüche 3 bis 6, **dadurch gekennzeichnet,**
**dass** die Lamellen (91) mittels eines Extrusionsverfahrens aus Kunststoff hergestellt sind, wobei eine Seite der jeweiligen Lamelle (91) mit einer reflektierenden metallisierten Folie (92) beschichtet ist.
